# EUROPÄISCHE PATENTSCHRIFT

(11) **EP 0 827 631 B1**
(45) Veröffentlichungstag und Bekanntmachung des Hinweises auf die Patenterteilung: **24.07.2002**
(21) Anmeldenummer: 96919582.5
(22) Anmeldetag: 20.05.1996
(51) Int. Cl.: H01L 21/306

(54) **VERFAHREN ZUR STRUKTURIERUNG PORÖSEN SILICIUMS**
PROCESS FOR STRUCTURING POROUS SILICON
PROCEDE DE STRUCTURATION DE SILICIUM POREUX

(30) Priorität: 22.05.1995 DE 19518371
(43) Veröffentlichungstag der Anmeldung: 11.03.1998
(73) Patentinhaber: Forschungszentrum Jülich GmbH, 52425 Jülich (DE)
(72) Erfinder: BERGER, Michael, D-53343 Wachtberg (DE); THÖNISSEN, Markus, D-41334 Nettetal (DE); GRÄBER, Jürgen, D-32351 Stemwede (DE); KRÜGER, Michael, D-52062 Aachen (DE); MARSO, Michel, D-52428 Jülich (DE); MÜNDER, Herbert, D-50127 Bergheim (DE); GLÜCK, Olaf, D-50931 Köln (DE); ARENS-FISCHER, Rüdiger, D-52066 Aachen (DE); LÜTH, Hans, D-52076 Aachen (DE)
(86) Internationale Anmeldenummer: DE9600913
(87) Internationale Veröffentlichungsnummer: WO9637911

(56) Entgegenhaltungen:
- EP-A- 0 563 625
- US-A- 3 929 529
- US-A- 3 962 052
- US-A- 4 765 865
- US-A- 5 458 518

## Beschreibung

Die Erfindung betrifft ein Verfahren zur Strukturierung porösen Siliciums gemäß dem Oberbegriff des Anspruchs 1.

Poröses Silicium (PS) ist aufgrund seiner Kompatibilität zur hochentwickelten Silicium(Si)-Mikroelektronik sowie seiner einfachen Herstellbarkeit ein vielversprechendes Material für Anwendungen z.B. im Bereich der Optoelektronik als LED [W. Lang, P. Steiner und F. Kozlowski, "Optoelectronic properties of porous silicon. The electroluminescent devices", in "Porous silicon science and technology", Winter school Les Houches 1994, Springer Verlag Berlin Heidelberg New York], Photodetektor [J.P. Zheng, K.L. Jiao, W.P. Shen, W.A. Anderson und H.S. Kwok, Appl. Phys. Lett. 61 (4), 459-461 (1992)] oder im Bereich der Sensorik als Gasflußsensor Bei der Integration von PS in komplexe Bauelementstrukturen sind Probleme bei der Strukturierung des PS gegeben. Beispielsweise variieren die entscheidenden Parameter der Ätztiefe und Porosität zwischen Rand und Mitte selektiv hergestellter PS-Bereiche. Auch kommt es zu starkem Unterätzen verwendeter Maskenstrukturen.

Verwendung findet PS als lichtemittierende Schicht in optoelektronischen Bauelementen, als optische Filter oder Spiegel, sowie als Wellenleiter. Zur Integration in komplexen Bauelementstrukturen sollte die räumliche Ausdehnung der PS-Bereiche möglichst gering gehalten werden. Hierzu existieren zur Zeit folgende, alternative Möglichkeiten:
1) zunächst wird eine großflächige PS-Schicht hergestellt und sodann anschließend so strukturiert, daß unerwünschte PS-Bereiche entfernt werden (wie zum Beispiel aus J. Electrochem. Soc.: Solid-State Science and Technology, Vol. 134, No. 8,Aug. 1987, pp. 1994-2000, oder Appl. Phys. Lett. 62 (18), 3 may 1993, pp. 2224-2226 bekannt) ;
2) eine Strukturierung des Substrates erfolgt vor der Ätzung des PS (wie zum Beispiel aus EP 563 625 A2 bekannt);

Im ersten Fall kommt es aufgrund der genannten Verfahrensschritte bei der Strukturierung zur Veränderung der Materialeigenschaften des PS, welche sich nachteilig auf die Verwendbarkeit eines solchen Verfahren in Bauelementen auswirkt. Nachteilig ist dabei zudem, daß alle übrigen Bauelemente einer solchen Device-Struktur auf die Verwendbarkeit eines solchen Verfahren in Bauelementen auswirkt. Nachteilig ist dabei zudem, daß alle übrigen Bauelemente einer solchen Device-Struktur nach Ätzung des PS hergestellt werden müssen. Viele der dabei nötigen Prozeßschritte, wie z.B. Oxidation, Einlegieren von Kontakten und Ausheilen von Defekten, führen dann ebenfalls bis hin zur Zerstörung des PS.

Demgegenüber können im zweiten Fall alle übrigen Bauelemente vor der Ätzung des PS hergestellt werden. Während der Ätzung bewirkt eine Maskenstruktur auf der Oberfläche des Substrates, daß diese Bauelemente vor der Ätzlösung geschützt werden und PS nur an den gewünschten Stellen entsteht (sgn. selektive Anodisierung). Dazu finden Maskenstrukturen aus Photolack, Si₃N₄, SiO₂, SiC oder Metallen sowie Kombinationen hieraus Verwendung. Die Eigenschaften solcher Maskenstrukturen sind dabei jedoch nachteilig vor der Ätzung festzulegen und konnten deshalb während der Ätzung nicht verändert werden.

Bei Verwendung solcher Maskenstrukturen zum Verfahren einer nachträglichen Ätzung treten zwei grundsätzliche Probleme auf: einerseits ist das Ätzprofil sowohl bezüglich der Ätztiefe als auch bezüglich der Porosität inhomogen, andererseits kommt es zum Unterätzen der Maske.

Außerdem ist eine gezielte, laterale Variation der Porosität, wie z.B. für Wellenleiterstrukturen benötigt werden könnte, nicht möglich.

US-A-4765865 offenbart ein Verfahren zum Ätzen von Silizium bei dem die Ätzrate durch Anlegen einer Spannung erhöht wird.

Es ist deshalb Aufgabe der Erfindung ein Verfahren zur Strukturierung von PS bereitzustellen, bei dem die Ätzbedingungen während der Ätzung variiert, insbesondere das Ätzprofil und der unterätzte Bereich jeweils bezüglich Tiefe bzw. Breite und Porosität reguliert werden können.

Die Aufgabe wird gelöst durch ein Verfahren gemäß der Gesamtheit der Merkmale nach Anspruch 1. Weitere zweckmäßige oder vorteilhafte Varianten finden sich in dem auf diesen rückbezogenen Unteranspruch.

Das erfindungsgemäße Verfahren befaßt sich mit der Beeinflussung des Ätztiefen- und Porositätsprofils von selektiv geätzten PS-Strukturen sowie der Steuerung des Unterätzens der Maskenstruktur. Im einzelnen ist vorgesehen, eine leitende oder halbleitende Schicht (z.B. aus Metall oder dotiertem Halbleiter) auf der Oberflä-Das erfindungsgemäße Verfahren befaßt sich mit der Beeinflussung des Ätztiefen- und Porositätsprofils von selektiv geätzten PS-Strukturen sowie der Steuerung des Unterätzens der Maskenstruktur. Im einzelnen ist vorgesehen, eine leitende oder halbleitende Schicht (z.B. aus Metall oder dotiertem Halbleiter) auf der Oberfläche des Substrates oder innerhalb des Substrates in Oberflächennähe vorzusehen. Zum Schutz dieser Schicht vor der Ätzlösung kann eine isolierende Schicht, z.B. aus Photolack, auf die leitende Schicht aufgebracht werden.

Während des Ätzvorganges wird zusätzlich zu der Spannung zwischen Rückseitenkontakt und Elektrolyt eine Spannung an die leitende Oberflächenschicht angelegt. Beide Spannungen können konstant sein oder zeitlich variiert werden. Das Verhältnis dieser beiden Spannungen bestimmt den räumlichen Verlauf des elektrischen Feldes im Substrat und somit die Stromdichteverteilung an der Grenzfläche zwischen Substrat und Ätzlösung. Da die Stromdichte sowohl Ätzrate als auch Porosität des entstehenden PS bestimmt, lassen sich das Ätztiefen- sowie das Porositätsprofil der PS-Struktur durch Variation der beiden Spannungen während der Ätzung beeinflussen.

Die erfindungsgemäße Maskierungstechnik ermöglicht außerdem die Steuerung des Unterätzens der Maskenstruktur. Es ist beispielsweise möglich, das Ausmaß des Unterätzens zu reduzieren oder eine PS-Struktur mit einer Schicht aus PS anderer Porosität zu ummanteln, beispielsweise für Wellenleiteranwendungen.

Wesentliche Vorteile des beschriebenen Verfahrens liegen in der einfachen technologischen Realisierbarkeit der Maskenstruktur und der Steuerbarkeit des Prozesses mit handelsüblicher Stromquelle. Zur Herstellung der Maskenstruktur können dieselben Materialien (z.B. Metalle, Dotierstoffe) und dieselben Verfahren (z.B. Photolithographie, Aufdampfen, Lift-Off und Einlegieren von Metallen, Implantation oder Diffusion von Dotierstoffen) wie in der Si-Mikroelektronik zur Zeit verwendet werden, zum Einsatz kommen. Im Ergebnis ist auf diese Weise ein gezieltes 3-dimensionales Design von PS-Strukturen möglich.

Die Erfindung ist im weiteren an Hand von Figuren und Ausführungsbeispiel näher erläutert. Es zeigen:
- Fig. 1:: Struktur nach dem Stand der Technik;
- Fig. 2:: erfindungsgemäßes Verfahren mit nicht-isolierender Schicht;
- Fig. 3:: Ätztiefenprofil von selektiv anodisiertem PS nach Figur 1;
- Fig.4:: Ätztiefenprofil von selektiv anodisiertem PS nach Figur 2;
- Fig. 5:: Wellenleiter in PS;
- Fig. 6a:: zeitliche Verlauf U_{PS};
- Fig. 6b:: zeitliche Verlauf U_{M};

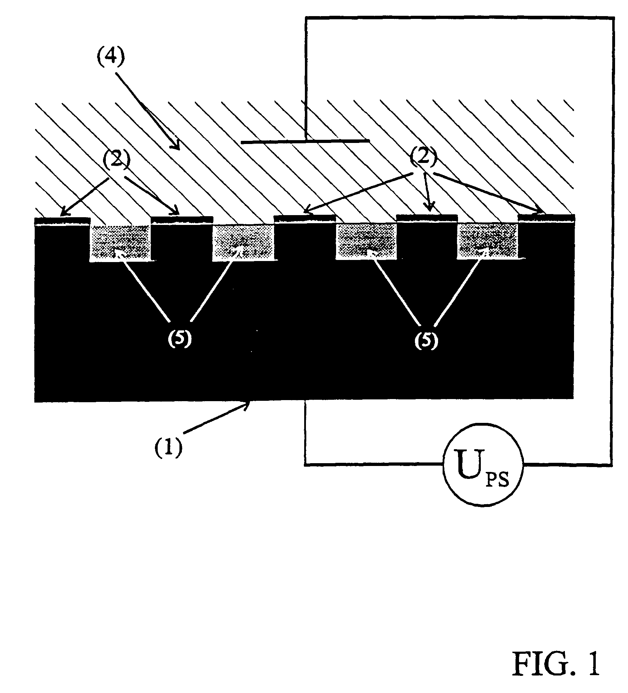

In der Figur 1 ist ein Substratbereich 1 aus Silicium mit vier Gräben 5 aus porösem Silicium im Querschnitt gezeigt. Über der Substratoberfläche befindet sich eine Ätzlösung 4, die beim Anlegen einer Spannung U_{PS} zwischen dieser und dem Substrat 1 zur Porosidierung der nicht durch Photolack 2 abgeschirmten Substratbereiche 5 führt und auf diese Weise die Grabenstruktur 5 bildet.

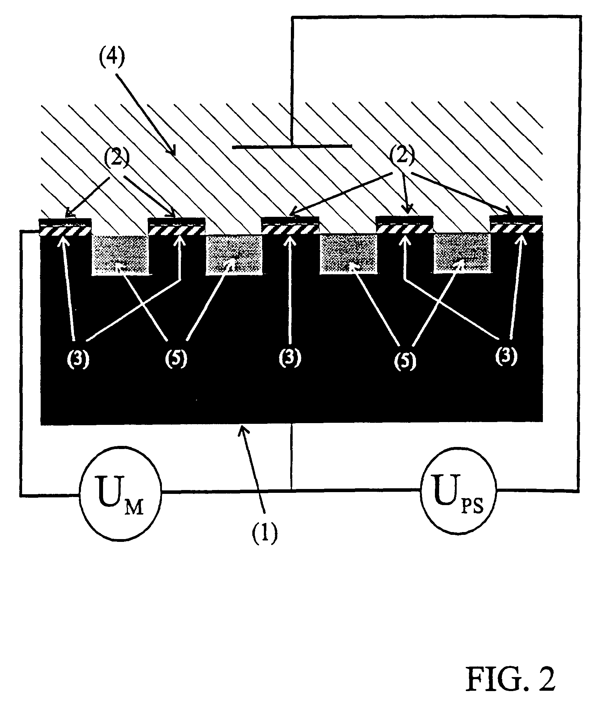

Im Gegensatz zu der in Figur 1 aus dem Stand der Technik entnehmbaren Struktur und Verfahrensweise ist in der Figur 2 eine Struktur mit Substratbereich 1 aus Silicium und mit vier Gräben 5 aus porösem Silicium im Querschnitt gezeigt. Zusätzlich ist dabei an den nicht zur Porosidierung vorgesehenen Bereichen der Substratoberfläche eine nicht-isolierende Schicht 3 vorgesehen. Diese kann metallisch oder auch halb-leitend gewählt werden und wurde auf die Spannung U_{M} zum Substrat 1 gelegt. In der Figur 2 ist auf dieser Schicht 3 der Photolack 2, insbesondere zum Schutz der Schicht 3 aufgebracht. Der Photolack 2 könnte unterbleiben, soweit die nicht-isolierende Schicht während der Porosidierung mit der Ätzlösung 4 dieser gegenüber ausreichend resistent ist.

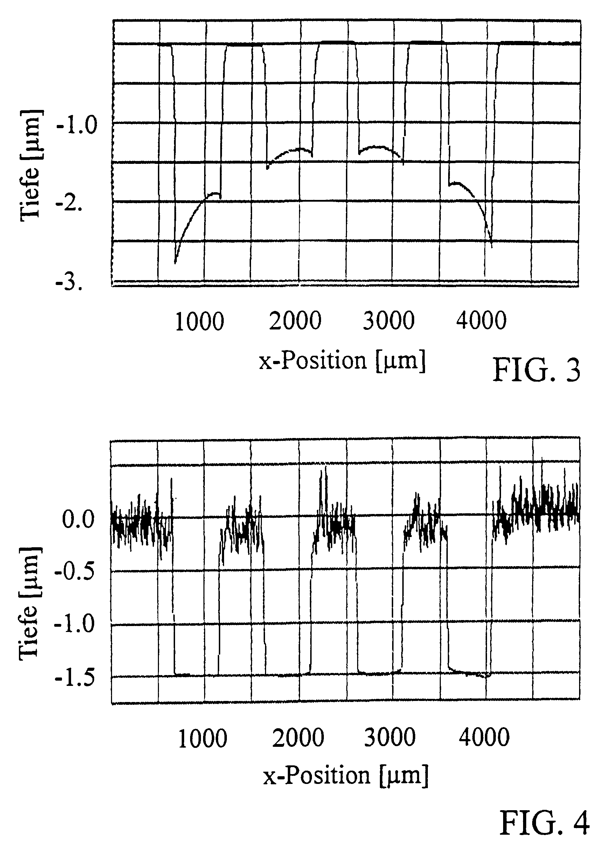

In der Figur 3 ist das Ergebnis einer Ätztiefenprofilmessung von p-dotiertem (2∗10¹⁵ cm⁻³), selektiv anodisiertem PS mit Struktur nach Figur 1 dargestellt. Die geätzte Struktur nach Figur 1 bestand dabei aus vier parallelen Streifen von jeweils 10 mm Länge und 0,50 mm Breite mit einem Abstand von jeweils 0,50 mm.

Nach der Ätzung wurde das PS mit NaOH entfernt und das Ätztiefenprofil mit einem Oberflächenprofiler gemessen. Die obere Messung zeigt die Variation der Ätztiefe bei Verwendung einer herkömmlichen Maskenstruktur aus Photolack. Deutlich erkennbar ist die starke Schwankung der erflgten Porosidierung in das Substrat innerhalb jedes der Gräben 5 sowie die starke Schwankungen und damit unregelmäßigen Teifenätzungen von Graben zu Graben.

Demgegenüber zeigt eine an der Struktur nach Figur 2 erfolgte, entsprechende Tiefenprofilmessung in der Figur 4 eine sehr definierte - , hier homogene - Tiefe von 1,5 µm in jedem der Gräben 5 sowie innerhalb eines einzelnen dieser Gräben 5, bei Verwendung der erfindungsgemäßen, aktiven Maskierungstechnik.

Verwendet wurde eine Maskenstruktur aus 50 nm Cr, 400 nm Au und 1400 nm Photolack. Die Metallschichten wurden 60 s bei 400 °C einlegiert. Durch gezielte Wahl der Parameter kann ein erwünschtes Profil gezielt eingestellt werden. Insbesondere ist es dabei vorstellbar, die fünf in Figur 2 gezeigten Bereiche der nicht-isolierenden Schicht 3 gegebenenfalls auf jeweils unterschiedlichen Spannungen U_{M} zueinander zu legen für die Dauer der Ätzung zur Porosidierung definierter Substratbereiche.

Zudem ist es vorstellbar, diese Spannung während der Ätzung zu ändern um auf diese Weise die Porosidierung im zeitlichen Verlauf aktiv zu beeinflussen, was mit der durch Figur 1 erläuterte Verfahrensweise nicht möglich ist.

Während der Ätzung wurden die Stromdichten j_{PS} durch die Grenzfläche zwischen dem Elektrolyten und PS und j_{M} durch die Grenzfläche zwischen Metall und PS konstant gehalten, wobei das Verhältnis j_{PS}/j_{M} = 0.5 betrug. Die Rauhigkeit der nicht geätzten Oberfläche wird durch das einlegierte Metall hervorgerufen. Die Ätztiefe ist dabei, im Gegensatz zur oberen Messung, homogen über die gesamte Struktur.

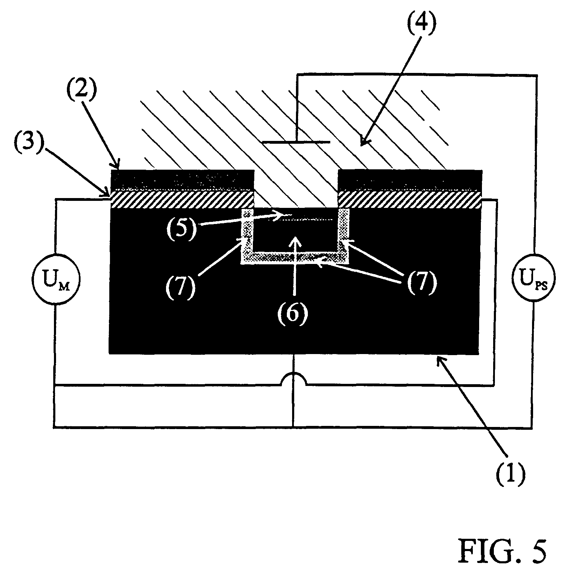

In der Figur 5 ist ein weiteres Beispiel für die Verwendung der aktiven Maskierungstechnik gezeigt. die Bildung eines Wellenleiters im PS. Dazu zeigt die Figur 5 eine Maskenstruktur aus einer Metallschicht 3 und einer Lackschicht 2 als Isolator zwischen Metall 3 und Elektrolyt 4. Die Strukturierung kann beispielsweise mit Photolithographie und Lift-off-Technik oder reaktivem Ionenätzen (RIE) erfolgen. Während der Ätzung können die angelegten Spannungen konstant gehalten oder variiert werden. Dargestellt ist der zeitliche Verlauf der Spannungen sowie das entstehende Porositätsprofil für eine Wellenleiterstruktur.

Beim Beispiel nach Figur 5 wurde zur Bildung eines Wellenleiters im Substrat 1 im Zeitraum 0<t<t₁ durch Anlegen einer Spannung U_{PS} zwischen Substrat 1 und Elektrolyt 4 im Bereich 5 eine hochporöse Schicht 5 geätzt und dabei ein Unterätzen der Metallmaske 3 durch Anlegen einer Spannung U_{M} an das Metall 3 verhindert.

Anschließend wurde im Zeitraum t₁<t<t₂ der niederporöse Kern 6 zur Bildung eines Wellenleiters 6 hergestellt und dabei das Unterätzen weiterhin verhindert. Zum Abschluß wurde für t₂<t<t₃ zur Ummantelung des Kerns 6 wiederum eine hochporöse Schicht 7 geätzt.

Damit diese Ummantelung diesen Kern nicht nur nach unten, sondern auch seitlich umschließt, wurde gleichzeitig die Spannung U_{M} reduziert, so daß ein seitliches Unterätzen der Maske mit der gleichen Porosität wie unterhalb des Kerns 6 erfolgte.

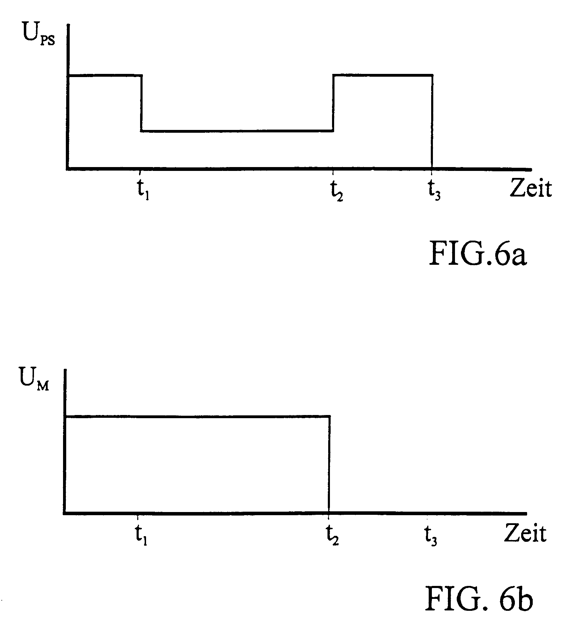

Die zeitlichen Verläufe der Spannungen U_{PS} und U_{M} im Beispiel nach Figur 5 sind in Figur 6 nochmals dargestellt im Vergleich.

## Patentansprüche

1. Verfahren zur Herstellung einer Struktur mit porösem Silicium, bei dem an der Oberfläche eines Siliciumsubstrats (1) mittels einer Ätzlösung (4) das Silicium porosidiert wird, wobei zwischen dem Substrat und der Ätzlösung zumindest während der Ätzung eine Spannung (U_{PS}) angelegt wird,
**dadurch gekennzeichnet,**
**daß** auf wenigstens einem nicht zur Porosidierung vorgesehenen Bereich der Substratoberfläche eine nicht-isolierende Schicht (3) aufgebracht wird und zwischen dieser Schicht und dem Substrat (1) während der Porosidierung eine elektrische Spannung (U_{M}) angelegt wird.

2. Verfahren nach Anspruch 1,
**dadurch gekennzeichnet,**
**daß** die Spannung (U_{M}) zur Bildung von Bereichen unterschiedlicher Porosität zeitlich und/oder örtlich unterschiedlich eingestellt wird.

## Claims

1. Method of manufacturing a structure with porous silicon, in which the silicon is made porous at the surface of a silicon substrate (1) by means of an etching solution (4) and in which, at least during the etching process, a voltage (U_{PS}) is applied between the substrate and the etching solution,
**characterized in that**
a non-insulating layer (3) is applied to at least one region of the substrate's surface that is not intended to be made porous and an electric voltage (U_{M}) is applied between this layer and the substrate (1) during the porosity treatment.

2. Method according to Claim 1,
**characterized in that**
the voltage (U_{M}) is applied for different periods of time and/or to different areas so as to form regions of varying porosity.

## Revendications

1. Procédé de production d'une structure ayant du silicium poreux, qui consiste à rendre poreux le silicium à la surface d'un substrat (1) en silicium au moyen d'une solution (4) d'attaque chimique en appliquant une tension (U_{PS}) entre le substrat et la solution d'attaque au moins pendant l'attaque,
**caractérisé en ce qu'**il consiste à déposer une couche (3) non isolante sur au moins une partie de la surface du substrat qu'il n'est pas prévu de rendre poreuse et à appliquer une tension (U_{M}) électrique entre cette couche et le substrat (1) pendant l'opération de mise sous forme poreuse.

2. Procédé suivant la revendication 1,
**caractérisé en ce qu'**il consiste à régler différemment dans le temps et/ou localement la tension (U_{M}) pour former des parties de porosité différente.
